# EUROPÄISCHE PATENTANMELDUNG

(11) **EP 0 987 716 A2**
(43) Veröffentlichungstag der Anmeldung: **22.03.2000**
(21) Anmeldenummer: 99117532.4
(22) Anmeldetag: 04.09.1999
(51) Int. Cl.: G11C 16/06

(54) **Verfahren zur Datensicherung eines EPROM**

(30) Priorität: 15.09.1998 DE 19842143
(71) Anmelder: WILO GmbH, D-44263 Dortmund (DE)
(72) Erfinder: Stephan, Waldemar, 44319 Dortmund (DE)
(74) Vertreter: COHAUSZ HANNIG DAWIDOWICZ & PARTNER

(57) **Zusammenfassung**

Verfahren zur Sicherung des Inhaltes eines von einer externen Spannungsversorgung unabhängigen und mittels elektronischer Signale beschreibbaren Permanentspeichers, der zur Speicherung digitaler Daten in einer elektronischen Rechenanlage eingesetzt wird, wobei die im Permanentspeicher 3 vorhandenen Daten über eine von der Rechenanlage unabhängige Leseleitung 7 in einen mit dem Permanentspeicher 3 in direkter mechanischer und elektrischer Verbindung stehenden flüchtigen Zwischenspeicher 6 übertragen werden und daß die Daten nachfolgend von dem Zwischenspeicher 6 über eine von der Recheneinheit unabhängige Schreibleitung 10 in den Permanentspeicher 3 geschrieben werden.

## Beschreibung

Die Erfindung betrifft ein Verfahren und eine Vorrichtung zur Sicherung des Inhaltes eines von einer externen Spannungsversorgung unabhängigen und mittels elektronischer Signale beschreibbaren Permanentspeichers, der zur Speicherung digitaler Daten in einer elektronischen Rechenanlage eingesetzt wird.

Permanentspeicher sind bekannt und werden in fast allen Rechenanlagen und elektronischen Schaltkreisen eingesetzt, die einen Mikroprozessor aufweisen. Dabei sind einerseits Permanentspeicher als ROM (Read Only Memory) bekannt, bei denen die Information unlöschbar eingraviert ist. Diese Speicher können mit herkömmlichen, in einem Rechner zur Verfügung stehenden Mitteln nicht beschrieben werden.

Daneben sind andere Permanentspeicher, sogenannte EPROM (Erasable Programmable ROM), bekannt, die auf elektrischem Wege mit Information beschrieben werden können. Zum Beschreiben eines EPROM wird eine hohe Spannung an die jeweilige Speicherzelle angelegt, so daß die Schwellen-spannung der Zelle herabgesetzt wird und die Elektronen in die Zelle wandern können. Auch EPROM unterliegen einem Alterungsprozeß, bei dem die Information langsam verloren geht. Dabei ist die Gefahr des Datenverlustes bei hohen, die Schwellenspannung beeinflussenden Temperaturen besonders hoch. Das erneute Beschreiben mit den bekannten Mitteln geht mit einem großen Aufwand einher und ist im normalen Betrieb der Rechenanlage bisher nicht möglich.

Aufgabe der Erfindung ist es daher, ein Verfahren zu schaffen, das es erlaubt, die Information auf elektronisch beschreibbaren Permanentspeichern auf einfache Weise zu sichern. Gleichzeitig ist es Aufgabe der Erfindung, eine einfach aufgebaute und kostengünstige Speichereinheit zu schaffen, mit der eine Sicherung der Daten problemlos möglich ist.

Diese Aufgabe wird durch ein Verfahren nach Anspruch 1 und eine Speichereinheit nach Anspruch 4 gelöst.

Die Besonderheit der Erfindung ist darin zu sehen, daß dem Permanentspeicher, der vorteilhafterweise ein EPROM ist, ein flüchtiger Speicher gleicher oder geringerer Größe zugeordnet ist, der außer der Datensicherung keine weiteren Aufgaben übernimmt. Die erfindungsgemäße Speichereinheit erlaubt die Herstellung einer identischen Kopie des Inhaltes des Permanentspeichers zur Sicherung innerhalb kürzester Zeit mit hoher Übertragungssicherheit.

Erfindungsgemäß ist der Zwischenspeicher gewissermaßen in den Permanentspeicher integriert, was dadurch zum Ausdruck kommt, daß der Zwischenspeicher in direkter mechanischer und elektrischer Verbindung mit dem Permanentspeicher steht. Dabei ist es besonders vorteilhaft, wenn der Zwischenspeicher am Permanentspeicher befestigt ist, wenn beide Speicher auf einer gemeinsamen Steckkarte angeordnet sind oder wenn ein Teil des Permanentspeichers selber als flüchtiger Zwischenspeicher ausgebildet ist oder als ein Chip. Auf jeden Fall bilden beide Speicher eine bauliche Einheit, die sich kostengünstig herstellen, leicht einsetzen und einfach handhaben läßt. Es ist darüberhinaus vorteilhaft, wenn die Speichereinheit, insbesondere die gemeinsame Steckkarte in den ursprünglich für den Permanentspeicher vorgesehenen Platz einsteckbar ist, so daß ein Nachrüsten alter Rechenanlagen keinerlei Probleme bereitet.

Der direkte Zusammenhang beider Speicher ist auch dadurch manifestiert, daß die Verbindungsleitungen für die Datenübertragung zwischen beiden Speichern unabhängig von der Infrastruktur der Rechenanlage sind. Vorteilhafterweise verlaufen die Leitungen von einem zum anderen Speicher, ohne daß sie die Speichereinheit, die beispielsweise auf der gemeinsamen Steckkarte angeordnet ist, verlassen. Die Schreib- und die Leseleitung können aus Gründen der Kosten- und der Platzersparnis dieselbe physikalische Leitung sein.

Mit der erfindungsgemäßen Speichereinheit können die Daten problemlos vom Permanentspeicher zum Zwischenspeicher und zurück übertragen werden. Dabei ist es für die Sicherheit der auf dem Permanentspeicher vorhandene Daten besonders vorteilhaft, wenn die Übertragung zur Sicherung in zyklischen Abständen erfolgt und die Wiederkehr einer Sicherung durch die Zyklenzeit vorgebbar ist.

In einer besonderen Ausführungsform des Verfahrens wird der Inhalt des Permanentspeichers nicht auf einmal, sondern in einzelnen Schritten übertragen, wobei pro Schritt ein vorher festgelegter Teil des Speichers gesichert wird. Dadurch wird eine Erhöhung der Übertragungssicherheit erreicht, da die kleineren Datenpakete leichter von Kontrollfunktionen auf einen korrekten Transfer hin überprüfbar sind. Außerdem kann die teilweise Sicherung mit einem kleineren Zwischenspeicher erfolgen, so daß die Herstellungskosten und die Baugröße der Speichereinheit reduziert werden können.

Um einen sicheren und schnellen Datentransfer zu gewährleisten, ist es vorteilhaft, wenn dem Zwischenspeicher eine von der Recheneinheit unabhängige Steuereinheit in Form eines Mikroprozessors zugeordnet ist, die den Datentransfer zwischen dem Permanentspeicher und dem Zwischenspeicher initiiert und kontrolliert. Die für die Datensicherung nötigen Programme können dabei auf dem Permanentspeicher geladen sein. Die Uabhängigkeit von der Recheneinheit bewirkt eine Autonomie der Speichereinheit. Die Autonomie ist vollkommen, wenn die Speichereinheit eine eigene Energiequelle in Form eines wiederaufladbaren Akkus aufweist.

Um die für das Beschreiben benötigte Spannung bereitzustellen ist es vorteilhaft, innerhalb der Speichereinheit einen Schreibverstärker vorzusehen. Mit diesem Verstärker kann gleichzeitig gewährleistet werden, daß die zu schreibende Information in ausreichender Qualität an die Speicherstelle im Permanentspeicher geschrieben wird. Als Pendant zum Schreibverstärker kann die Speichereinheit in einer vorteilhaften Ausführungsform einen Leseverstärker aufweisen, der die in ihrer Qualität möglicherweise unzureichende Information vom Permanentspeicher liest und aufbereitet.

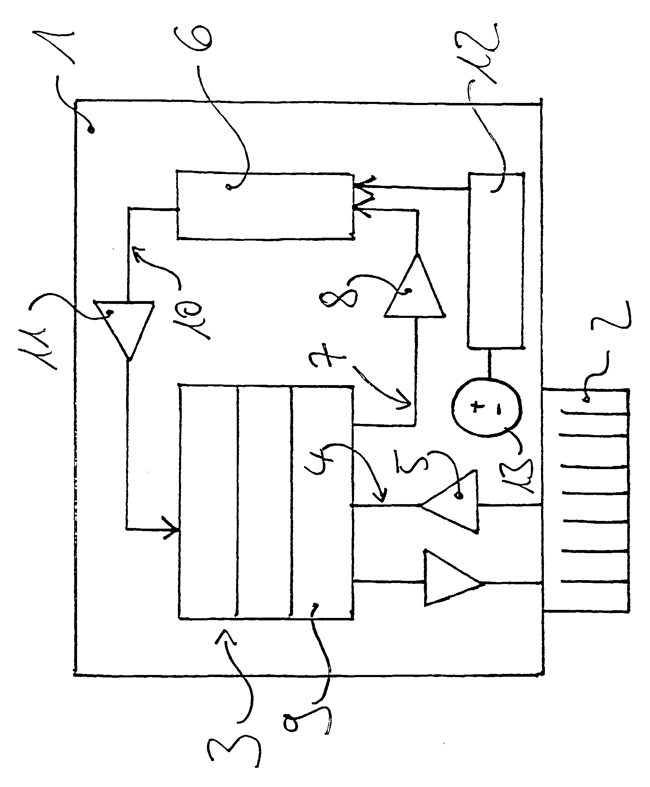

Das erfindungsgemäße Verfahren wird im folgenden anhand der in der Zeichnung gezeigten Ausführungsformen der erfindungsgemäßen Speichereinheit näher beschrieben.

In der Zeichnung ist eine erfindungsgemäße Speichereinheit dargestellt. Diese Speichereinheit ist auf einem Elektronikmodul in Form einer Steckkarte 1 angeordnet, wobei die Steckkarte 1 mit einem Stecker 2 in ein entsprechendes Schloß im Computer einsteckbar ist und so mit der Datenleitung (Bus) des Computers verbunden wird. Die Speichereinheit weist als Herzstück einen von jeglicher Spannungsversorgung unabhängigen Permanentspeicher 3 auf, der zur Speicherung digitaler Daten dient. Der Permanentspeicher 3 ist in diesem speziellen Falle ein EPROM, das mit elektronischen Signalen über eine Leitung 4 bei zwischengeschaltetem Schreibverstärker 5 beschreibbar ist.

Neben dem Permanentspeicher 3 befindet sich auf der Karte 1 ein flüchtiger Zwischenspeicher 6, der über eine auf der Karte 1 verlaufende und von der Rechenanlage unabhängige Datenleitung 7 mit dem Permanentspeichers 3 verbunden ist. Über die Datenleitung 7, können die auf dem Permanentspeicher 3 vorhanden Daten auf den Zwischenspeicher 6 übertragen werden, wobei die Daten zunächst von einem Leseverstärker 8 aufbereitet werden. In der gezeigten Ausführungsform ist der Permanentspeicher 3 in drei gleichgroße Blöcke 9 aufgeteilt, wobei einer der Blöcke 9 die Speicherkapazität des Permanentspeichers 3 hat. Der auf den Zwischenspeicher 6 übertragene Inhalt des Permanentspeichers 3 kann von dort über eine Schreibleitung 10 wieder auf den Permanentspeicher 3 rückübertragen weren. Bei der Rückübertragung werden die Daten von einem Schreibverstärker 11 aufgearbeitet, der gleichzeitig die zum Beschreiben des EPROM benötigte Spannung bereitstellt.

Die Organisation der Datensicherung wird von einer Steuereinheit 12 vorgenommen, die gleichfalls auf der Karte 1 untergebracht ist. Die Steuereinheit 12 ist von der Recheneinheit unabhängig und initiiert und kontrolliert den Datentransfer zwischen dem Permanentspeicher 3 und dem Zwischenspeicher 6. Auf der Karte 1 befindet sich ein wiederaufladbarar Akku 13, mit dem eine separate Spannungsversorgung gewährleistet ist.

Die beschriebene Speichereinheit erlaubt die Durchführung des Verfahren zur Sicherung des Inhaltes des Permanentspeichers 3, wobei die im Permanentspeicher 3 vorhandenen Daten über die von der Rechenanlage unabhängige Leseleitung 7 in den mit dem Permanentspeicher 3 in direkter mechanischer und elektrischer Verbindung stehenden flüchtigen Zwischenspeicher 6 übertragen und von dort nachfolgend über die Schreibleitung 10 wieder in den Permanentspeicher 9 geschrieben werden.

## Patentansprüche

1. Verfahren zur Sicherung des Inhaltes eines von einer externen Spannungsversorgung unabhängigen und mittels elektronischer Signale beschreibbaren Permanentspeichers, der zur Speicherung digitaler Daten in einer elektronischen Rechenanlage eingesetzt wird,
**dadurch gekennzeichnet**, daß die im Permanentspeicher (3) vorhandenen Daten über eine von der Rechenanlage unabhängige Leseleitung (7) in einen mit dem Permanentspeicher (3) in direkter mechanischer und elektrischer Verbindung stehenden flüchtigen Zwischenspeicher (6) übertragen werden und daß die Daten nachfolgend von dem Zwischenspeicher (6) über eine von der Recheneinheit unabhängige Schreibleitung (10) in den Permanentspeicher (3) geschrieben werden.

2. Verfahren nach Anspruch 1,
**dadurch gekennzeichnet**, daß die Sicherung in vorgebbaren zyklischen Abständen erfolgt.

3. Verfahren nach Anspruch 1 oder 2,
**dadurch gekennzeichnet**, daß der Inhalt des Permanentspeichers (3) in Teile (9) aufgeteilt wird und die Sicherung in mehreren aufeinanderfolgenden Zyklen erfolgt.

4. Speichereinheit mit einem von einer Spannungsversorgung unabhängigen Permanentspeicher zur Speicherung digitaler Daten, der mittels elektronischer Signale über eine Anschlußleitung beschreibbar ist und der in einer elektronischen Rechenanlage verwendbar ist,
**dadurch gekennzeichnet**, daß dem Permanentspeicher (3) ein flüchtiger Zwischenspeicher (6) zugeordnet ist, der mit dem Permanentspeicher (3) in direkter mechanischer und elektrischer Verbindung steht, wobei der Zwischenspeicher (6) über eine von der Rechenanlage unabhängige Datenleitung (7) mit dem Inhalt des Permanentspeichers (3) beschreibbar ist und wobei vom Zwischenspeicher (6) die aus dem Permanentspeicher (3) gelesenen Daten auf den Permanentspeicher (3) schreibbar sind.

5. Speichereinheit nach Anspruch 4,
**dadurch gekennzeichnet**, daß die Größe des Zwischenspeichers (6) kleiner oder gleich der Größe des Permanentspeichers (3) ist.

6. Speichereinheit nach Anspruch 4,
**dadurch gekennzeichnet**, daß der Zwischenspeicher (6) am Permanentspeicher (3) befestigt ist.

7. Speichereinheit nach Anspruch 5 oder 6,
**dadurch gekennzeichnet**, daß dem Zwischenspeicher (6) eine von der Recheneinheit unabhängige Steuereinheit (12) zugeordnet ist, die den Datentransfer zwischen dem Permanentspeicher (3) und dem Zwischenspeicher (6) initiiert und kontrolliert.

8. Speichereinheit nach einem der vorherigen Ansprüche,
**dadurch gekennzeichnet**, daß der Permanentspeicher (3) in Blöcke (9) aufgeteilt ist, die der Größe des Zwischenspeichers (6) entsprechen.

9. Speichereinheit nach einem der vorherigen Ansprüche,
**dadurch gekennzeichnet**, daß der Permanentspeicher (3) ein EPROM ist.

10. Speichereinheit nach einem der vorherigen Ansprüche,
**dadurch gekennzeichnet**, daß die Leseleitung (7) und die Schreibleitung (10) dieselbe physikalische Datenleitung sind.

11. Speichereinheit nach einem der vorherigen Ansprüche,
**dadurch gekennzeichnet**, daß der Permanentspeicher (3), der Zwischenspeicher (6) und die Steuereinheit (12) auf einem separaten Elektronikmodul in der Art einer Steckkarte (1) angeordnet sind, die mittels einer mechanischen Steckverbindung (2) auf die Datenleitung der Rechenanlage aufsetzbar ist.

12. Speichereinheit nach Anspruch 11,
**dadurch gekennzeichnet**, daß das Elektronikmodul innerhalb der Rechenanlage in den für den Permanentspeicher (3) vorgesehenen Steckplatz einsteckbar ist.

13. Speichereinheit nach Anspruch 11 oder 12,
**dadurch gekennzeichnet**, daß auf dem Elektronikmodul ein Schreibverstärker (5,11) und/oder ein Leseverstärker (8) angeordnet sind bzw. ist.

14. Speichereinheit nach einem der vorherigen Ansprüche,
**dadurch gekennzeichnet**, daß auf dem Elektronikmodul (1) eine separate Spannungsversorgung, insbesondere in Form eines wiederaufladbaren Akkus (13) angeordnet ist.
